(19) Europäisches Patentamt
European Patent Office
Office européen des brevets

(11) **EP 1 886 402 B1**

## (12) FASCICULE DE BREVET EUROPEEN

(45) Date de publication et mention
de la délivrance du brevet:
**02.05.2018 Bulletin 2018/18**

(21) Numéro de dépôt: **06794429.8**

(22) Date de dépôt: **15.05.2006**

(51) Int Cl.:
**H02J 7/14** *(2006.01)*      **H02P 9/00** *(2006.01)*

(86) Numéro de dépôt international:
**PCT/FR2006/050444**

(87) Numéro de publication internationale:
**WO 2007/000528 (04.01.2007 Gazette 2007/01)**

(54) **PROCEDE ET DISPOSITIF D'ESTIMATION DU COURANT DELIVRE PAR UN ALTERNATEUR POUR VEHICULE AUTOMOBILE**

VERFAHREN UND VORRICHTUNG ZUR BERECHNUNG DES STROMES EINES DREHSTROMGENERATORS FÜR EIN KRAFTFAHRZEUG

METHOD AND DEVICE FOR ESTIMATING THE CURRENT OUTPUT BY AN ALTERNATOR FOR A MOTOR VEHICLE

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **31.05.2005 FR 0505498**
**20.10.2005 FR 0510703**

(43) Date de publication de la demande:
**13.02.2008 Bulletin 2008/07**

(73) Titulaire: **VALEO EQUIPEMENTS ELECTRIQUES MOTEUR**
**94017 Créteil Cedex (FR)**

(72) Inventeurs:
• **PIERRET, Jean-Marie**
**F-75012 Paris (FR)**
• **RECHDAN, Raymond**
**F-94410 Saint Maurice (FR)**

(56) Documents cités:
**EP-A- 1 063 764      WO-A-03/058793**
**DE-A1- 19 941 004      FR-A- 2 841 341**

**EP 1 886 402 B1**

**Description**

La présente invention concerne un procédé et un dispositif d'estimation du courant débité par un alternateur (ou un alterno-démarreur) pour véhicule automobile. Elle concerne également une unité de régulation de la tension délivrée par une telle machine, communément appelée régulateur de l'alternateur.

L'invention s'applique à tous types de véhicules nécessitant, par exemple, une gestion du ralenti moteur en tenant compte du couple imposé par l'alternateur au moteur thermique lors des appels de charges (ce couple dépendant fortement du courant délivré par l'alternateur), et/ou une gestion sophistiquée du bilan de charge de la batterie du véhicule. Le procédé et le dispositif permettent en effet de fournir à une unité de contrôle moteur ou à tout autre calculateur interne au véhicule, une valeur estimée du courant délivré par l'alternateur.

Les informations habituellement délivrées par l'alternateur sont le rapport cyclique du signal d'excitation (PWM) et/ou la valeur du courant d'excitation mesurée par exemple par le régulateur de tension batterie (voir le document WO 02/071570). Ces informations sont traitées par les calculateurs pour en déduire le courant de sortie et le couple résistant de l'alternateur.

Le rapport cyclique du signal d'excitation est toutefois une mauvaise information pour en déduire la valeur du courant et le couple résistant délivrés par l'alternateur. En effet, la résistance du rotor varie fortement avec la température, et le rapport cyclique du signal d'excitation fournit une mauvaise image du courant d'excitation qui est utilisé ensuite pour estimer le courant et le couple résistant délivrés par l'alternateur. On peut remédier partiellement à ce problème en faisant intervenir la température du régulateur (plus facile à mesurer que la température de l'inducteur qui est en rotation), mais cette compensation reste approximative car la température du régulateur n'est pas liée directement à la température du bobinage inducteur.

Le courant d'excitation est déjà une meilleure information pour en déduire la valeur du courant et le couple résistant délivrés par l'alternateur. En effet, le courant d'excitation traverse le régulateur de tension batterie et peut être facilement mesuré par ce dernier (par exemple via un shunt ou un miroir de courant). Cependant le calculateur d'un véhicule qui exploite cette information doit avoir en mémoire les caractéristiques (sous forme de tables de valeurs préenregistrées) de tous les alternateurs qui peuvent être montés sur ce véhicule, ce qui mobilise une taille mémoire importante dans le calculateur et reste une gestion lourde pour le constructeur du véhicule.

Un moyen permettant d'éviter ces problèmes serait que l'alternateur délivre lui-même la valeur du courant qu'il débite, ce qui peut être réalisé de différentes façons.

On pourrait utiliser un shunt ou tout autre capteur qui mesurerait directement le courant débité par l'alternateur. Mais ceci compliquerait fortement l'architecture mécanique de l'alternateur par des connexions et des composants supplémentaires. En outre, le shunt devrait supporter des courants de l'ordre de 200 ampères sans échauffement excessif (quelques watts seulement), ce qui rendrait la mesure peu précise car on devrait mesurer des tensions de quelques millivolts ou dizaine de millivolts aux bornes du shunt.

On pourrait aussi prévoir la détermination du débit de l'alternateur à partir du courant d'excitation, effectuée par le régulateur de tension batterie. Une telle détermination, effectuée de façon conforme à l'art antérieur précité, nécessiterait toutefois une taille mémoire importante incompatible avec la taille mémoire limitée des microcontrôleurs incorporés aux régulateurs de tension conventionnels. Cette détermination est en effet habituellement réalisée à partir d'une table complexe. Cette table doit mémoriser la valeur du débit en fonction de la vitesse de rotation de l'alternateur, du courant d'excitation, de la température et de la tension batterie mesurée par le régulateur. Même en pratiquant des interpolations entre les valeurs données par la table, les ressources nécessaires sont incompatibles avec la taille mémoire disponible dans les petits microcontrôleurs incorporés dans les régulateurs.

Le document DE 19941004 A1 décrit un procédé et un dispositif consistant à déterminer et mémoriser le courant de sortie et la tension de sortie d'un générateur avec le régulateur de tension en fonction de la tension du régulateur, la vitesse de rotation de l'arbre du générateur et la température de l'air d'admission.

Le document WO03/058793 décrit un modèle de générateur permettant de déterminer des grandeurs électriques, mécaniques et/ou thermiques d'un générateur, notamment pour un réseau de bord d'automobile.

Le document EP 1063764 décrit un régulateur avec contrôle de sortie d'un alternateur et de la puissance d'entrée comprenant un tachymétre.

La solution proposée ici, selon des modes de réalisation de la présente invention, consiste à réaliser le calcul du débit à partir de la mesure du courant d'excitation et selon un schéma équivalent simplifié de l'alternateur.

Selon un premier aspect, l'invention propose en effet un procédé d'estimation du courant délivré par un alternateur pour véhicule automobile comprenant le calcul d'une valeur de sortie représentative du courant délivré par l'alternateur à partir d'une première valeur d'entrée représentative d'un courant d'excitation de l'alternateur d'une part, et d'une seconde valeur d'entrée représentative de la vitesse de rotation de l'alternateur, d'autre part, le calcul de la valeur de sortie comprenant les étapes de :

/a/ calcul d'un premier terme sensiblement proportionnel à la première valeur d'entrée ;

/b/ calcul d'un second terme sensiblement inversement proportionnel à la seconde valeur d'entrée; et,

/c/ soustraction du second terme à partir du premier terme pour obtenir la valeur de sortie.

L'introduction de coefficients correctifs permet d'ajuster le résultat du calcul à la valeur réelle du débit d'un alternateur prédéterminé.

Le procédé peut être mis en oeuvre au niveau d'une unité de régulation de la tension délivrée par l'alternateur (communément appelée régulateur de tension batterie, ou encore régulateur).

Par exemple, à l'étape /b/, la seconde valeur d'entrée peut être augmentée d'une première valeur additive non nulle déterminée. Cette première valeur additive, qui peut être constante, permet de réaliser un décalage en abscisse sur la seconde valeur d'entrée pour la caractéristique donnant la valeur de sortie en fonction de la seconde valeur d'entrée. Cela permet de tenir compte du seuil de la vitesse de rotation (dite vitesse d'amorçage) en dessous duquel un alternateur ne débite en principe pas de courant, en décalant la valeur représentative de la vitesse de rotation de l'alternateur. De même, à l'étape /a/, la première valeur d'entrée peut être augmentée d'une seconde valeur additive non nulle. Cette seconde valeur additive, qui peut être constante, permet de réaliser un décalage en ordonnée sur la première valeur d'entrée pour la caractéristique donnant la valeur de sortie en fonction de la première valeur d'entrée. Cela permet de compenser l'effet de la rémanence du circuit magnétique sur l'excitation en décalant la valeur représentative du courant d'excitation.

Egalement, le calcul de la valeur de sortie peut comprendre, en outre, après l'étape /c/, l'ajout d'une troisième valeur additive non nulle. Cette troisième valeur additive, qui peut être constante, permet de réaliser un décalage en ordonnée sur la valeur de sortie pour la caractéristique donnant la valeur de sortie en fonction de la première valeur d'entrée et de la seconde valeur d'entrée. Cela permet en particulier de tenir compte du rendement de la machine.

Dans un mode de réalisation, le second terme dépend d'un paramètre représentatif de la température des bobinages d'induit de l'alternateur. On prend ainsi en compte la variation du débit de l'alternateur en fonction de cette température.

En variante, un jeu de paramètres est sélectionné en fonction d'un paramètre représentatif de la température des bobinages d'induit de l'alternateur. Ce jeu de paramètres comprend un premier coefficient multiplicatif intervenant à l'étape /a/, un second coefficient multiplicatif intervenant à l'étape /b/, la première valeur additive, la deuxième valeur additive, et/ou la troisième valeur additive.

Dans l'un et l'autre cas, le paramètre représentatif de la température des bobinages d'induit de l'alternateur peut par exemple être mesuré au niveau du régulateur. Cette mesure est plus facile à réaliser qu'une mesure au niveau des bobinages d'induit, la température au niveau du régulateur étant toutefois fonction de la température au niveau de ces bobinages, étant donné la proximité entre les deux.

Dans un mode de réalisation, la première valeur d'entrée (représentative du courant d'excitation) est également mesurée au niveau de l'unité de régulation de la tension délivrée par l'alternateur. On peut ainsi tirer avantage de la méthode décrite dans le document WO 02/071570 précité.

Un deuxième aspect de l'invention se rapporte à un dispositif d'estimation du courant délivré par un alternateur pour véhicule automobile comprenant des moyens de calcul d'une valeur de sortie représentative du courant délivré par l'alternateur qui sont configurés pour calculer ladite valeur de sortie à partir d'une première valeur d'entrée représentative d'un courant d'excitation de l'alternateur d'une part, et d'une seconde valeur d'entrée représentative de la vitesse de rotation de l'alternateur, d'autre part, dans lequel les moyens de calcul de la valeur de sortie comprennent:

/a/ des premiers moyens de calcul configurés pour calculer un premier terme sensiblement proportionnel à la première valeur d'entrée ;

/b/ des deuxièmes moyens de calcul configurés pour calculer un second terme sensiblement inversement proportionnel à la seconde valeur d'entrée; et,

/c/ des troisièmes moyens de calcul configurés pour soustraire le second terme du premier terme pour obtenir la valeur de sortie.

Le dispositif peut avantageusement comprendre des moyens pour la mise en oeuvre des modes de réalisation particuliers du procédé qui ont été présentés plus haut.

Un tel dispositif peut être réalisé sous la forme d'un microcontrôleur correctement programmé.

Un troisième aspect de l'invention se rapporte à une unité de régulation de la tension délivrée par un alternateur pour véhicule automobile, comprenant un dispositif d'estimation du courant délivré par l'alternateur selon le deuxième aspect.

Dans un mode de réalisation, l'unité de régulation comprend en outre des moyens de calcul du couple appliqué à l'arbre de l'alternateur. Ce couple (ou moment de couple) est le couple mécanique résistant transmis par l'alternateur au moteur thermique du véhicule automobile. Sa prise en compte par une unité de contrôle moteur (telle qu'un calculateur d'injection, par exemple), permet d'adapter la quantité de carburant injectée dans le moteur thermique. On peut ainsi éviter des problèmes de calages intempestifs du moteur thermique dus à la régulation du courant de charge de la batterie.

Par exemple, le couple appliqué à l'arbre de l'alternateur est calculé comme la somme du couple utile, du couple lié aux pertes électriques, et du couple lié aux pertes mécaniques.

Le couple utile peut être calculé comme le rapport de la puissance utile sur la vitesse de rotation de l'alternateur, la puissance utile étant calculée comme le produit de la tension de sortie de l'alternateur par la valeur (estimée selon le procédé selon le premier aspect) du courant délivré par l'alternateur.

Le couple lié aux pertes électriques peut être calculé comme le rapport des pertes électriques sur la vitesse de rotation de l'alternateur, les pertes électriques étant par exemple calculées grâce à une fonction du second ordre de la valeur estimée (selon le procédé selon le premier aspect) du courant délivré par l'alternateur.

Le couple lié aux pertes mécaniques peut être calculé grâce à une fonction du second degré de la vitesse de rotation de l'alternateur.

Dans un autre mode de réalisation encore, l'unité de régulation comprend en outre des moyens de calcul du rendement de l'alternateur. Ce rendement peut par exemple être calculé comme le rapport du couple utile sur le couple appliqué à l'arbre de l'alternateur. La fourniture de la valeur du rendement de l'alternateur peut avoir un intérêt, par exemple, pour des opérations de diagnostique et/ou de maintenance.

Enfin, un quatrième aspect de l'invention se rapporte à un alternateur pour véhicule automobile, comprenant une unité de régulation de la tension délivrée par l'alternateur selon le troisième aspect.

D'autres caractéristiques et avantages de l'invention apparaîtront encore à la lecture de la description qui va suivre. Celle-ci est purement illustrative et doit être lue en regard des dessins annexés sur lesquels :

- la figure 1 est un schéma équivalent simplifié d'un alternateur (ou un alterno-démareur) en fonctionnement, selon un exemple de modélisation ;
- la figure 2 et la figure 3 sont des schémas illustrant respectivement un premier exemple et un second exemple de modélisation de l'induit d'un alternateur ;
- la figure 4 est un graphe montrant un réseaux de caractéristiques donnant la valeur de sortie (représentative du débit de l'alternateur) en fonction de la seconde valeur d'entrée (représentative de la vitesse de rotation de l'alternateur) sans prendre en compte de valeurs additives ;
- la figure 5 est un graphe montrant un réseaux de caractéristiques donnant la valeur de sortie (représentative du débit de l'alternateur) en fonction de la seconde valeur d'entrée (représentative de la vitesse de rotation de l'alternateur), avec des valeurs additives permettant de se rapprocher des caractéristiques donnant le courant délivré par l'alternateur en fonction de sa vitesse de rotation, relevées sur un alternateur réel ;
- la figure 6 est un schéma équivalent d'un alternateur en fonctionnement, selon un autre exemple de modélisation permettant de simplifier les calculs ;
- la figure 7 est un diagramme d'étapes illustrant un exemple d'algorithme de sélection des coefficients multiplicatifs et des valeurs additives, pour une température déterminée des bobinages d'induit, dans le cadre de la modélisation de la figure 6 ;
- la figure 8 est un diagramme d'étapes illustrant un exemple d'algorithme de calcul du débit de l'alternateur avec la modélisation de la figure 6;
- la figure 9 est un graphe donnant l'allure du couple lié aux pertes mécaniques en fonction de la vitesse de rotation, tel que calculé dans des modes de réalisation de la présente invention;
- la figure 10 est un graphe donnant l'allure du couple appliqué sur l'arbre d'un alternateur en fonction de la vitesse de rotation, tel que calculé dans des modes de réalisation de la présente invention pour différentes valeurs du courant d'excitation; et,
- la figure 11 est un graphe donnant l'allure du rendement d'un alternateur en fonction de la vitesse de rotation, tel que calculé dans des modes de réalisation de la présente invention pour différentes valeurs du courant d'excitation.

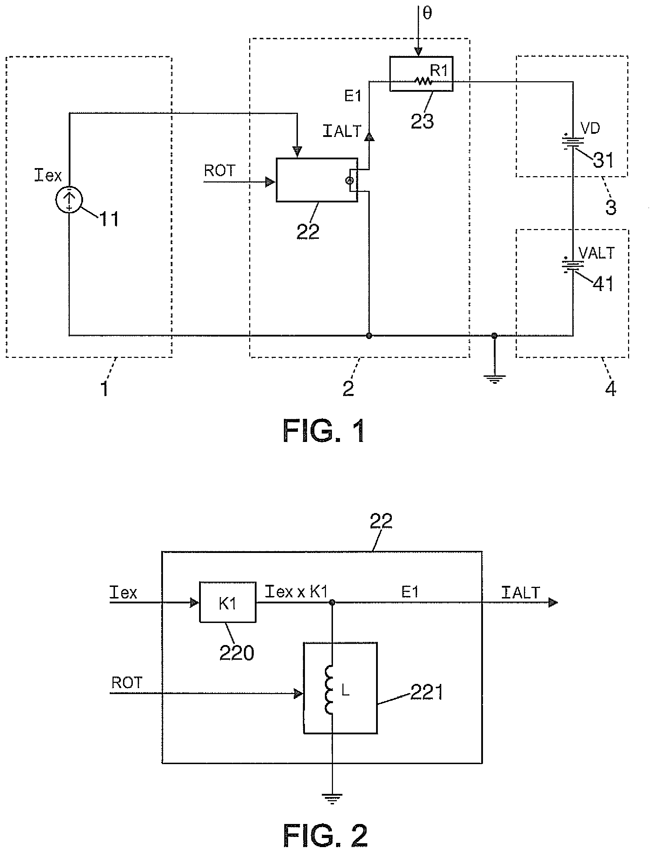

En référence à la figure 1, un schéma équivalent simplifié d'un alternateur va être présenté, dans lequel les différents paramètres ne sont pas modélisés en mode alternatif. En effet, pour simplifier les calculs mis en oeuvre dans le microcontrôleur du régulateur de l'alternateur, on ne considère que des paramètres continus équivalents (en courants et tensions) pour modéliser le débit de l'alternateur réel. En conséquence, le schéma équivalent simplifié ne fait intervenir aucun courant ni aucune tension alternatifs, qu'il faudrait redresser. En particulier, les inductances (dont les impédances augmentent proportionnellement à la vitesse de rotation) sont remplacées par des résistances dont les valeurs augmentent également proportionnellement à la vitesse de rotation.

L'inducteur 1 (par exemple le rotor) de l'alternateur est représenté en partie gauche de la figure 1. Le courant d'excitation lex de l'alternateur est modélisé par une source de courant continu 11. Ce courant (bien réel) est par exemple mesuré par le régulateur. De cette façon, la variation de résistance de l'inducteur en fonction de la température est prise en compte dans les calculs, ainsi que l'effet de la tension d'alimentation de l'inducteur.

L'induit 2 (par exemple le stator) de l'alternateur est représenté en partie médiane de la figure 1. Cet induit comporte une source de courant continu 22 et une résistance 23 de valeur R1 représentant la résistance réelle de l'induit. La source de courant 22 délivre un courant continu qui correspond au courant délivré par l'alternateur (courant induit), en fonction du courant d'excitation Iex et de la vitesse de rotation ROT de l'alternateur. La résistance 23 est traversée par ce courant. La vitesse de rotation est mesurée de façon connue, par tout capteur approprié, par exemple un capteur à effet Hall, ou plus simplement à partir des tensions de phase dont la fréquence est proportionnelle à la vitesse de rotation. En pratique, la résistance R1 dépend de la température $\theta$ des bobinages d'induit. Cette température peut être mesurée par un capteur approprié, disposé au niveau de ces bobinages. On verra plus loin, toutefois, qu'il est possible de faire autrement quand la température des bobinages ne peut pas être facilement mesurée.

La partie droite de la figure 1 comprend une source de tension continue 31 qui modélise la chute de tension VD dans le pont redresseur 3 de l'alternateur, ainsi qu'une source de tension continue 41 qui modélise la charge 4 sur laquelle est appliquée la tension de sortie VALT de l'alternateur. La tension de sortie VALT de l'alternateur est mesurée par le régulateur et est régulée par ce dernier.

En référence aux figures 1 et 2, la source de courant 22 délivre la valeur du courant IALT débité par l'alternateur, en fonction du courant d'excitation Iex, de la vitesse de rotation ROT, et de la valeur de la force électromotrice E1.

Cette force électromotrice E1 est égale la somme de la tension de sortie VALT, de la chute de tension dans le pont redresseur VD et de la chute de tension dans la résistance R1, suivant la relation suivante :

$$E1 = VALT + VD + R1 \times IALT \qquad (1)$$

En première approximation et aux fortes vitesses de rotation (de l'ordre de 20000 tours/min), on peut estimer que le débit de l'alternateur est proportionnel au courant d'excitation. On a alors la relation suivante :

$$IALT = K1 \times Iex \qquad (2)$$

où K1 est un coefficient multiplicatif déterminé, par exemple une constante.

Par contre, l'induit de l'alternateur comporte une inductance principale de stator 221, de valeur L, qui dérive tout ou partie du courant K1×Iex vers la masse. Cette inductance présente une impédance L$\omega$ proportionnelle à la vitesse de rotation ROT de l'alternateur. En conséquence, le courant dérivé par l'inductance 221 est faible aux fortes vitesses de rotation et important aux faibles vitesses de rotation de l'alternateur (de l'ordre de 1000 à 1200 tours/min). Aux très faibles vitesses de rotation (inférieures à la vitesse d'amorçage, à partir de laquelle l'alternateur commence à débiter), tout le courant K1×Iex est dérivé par l'inductance 221. Le schéma équivalent représente alors un alternateur dont la vitesse de rotation est trop faible pour pouvoir débiter.

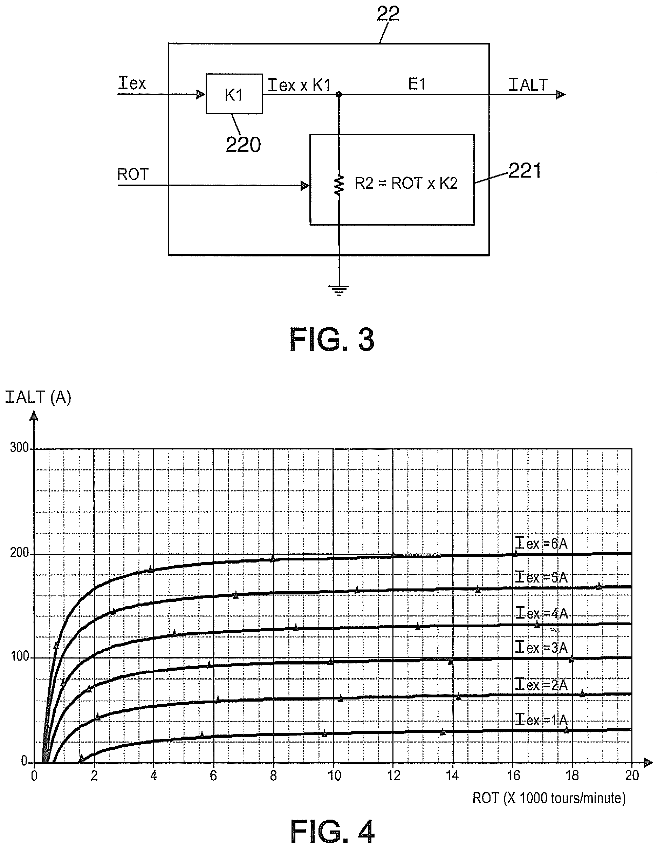

En référence à la figure 3, le schéma équivalent ne fonctionnant qu'en mode continu, l'impédance L$\omega$ de l'inductance 221 est remplacée par une résistance R2 dont la valeur est proportionnelle à la vitesse de rotation ROT, suivant la relation :

$$L\omega = K2 \times ROT \qquad (3)$$

où K2 est un coefficient multiplicatif déterminé, par exemple une constante.

Le courant $I_L$ dérivé par cette résistance est donné par :

$$I_L = \frac{E1}{(ROT \times K2)} \qquad (4)$$

Le débit IALT de l'alternateur, qui est égal à IALT=Iex×K1-$I_L$, est alors donné par la relation :

$$IALT = Iex \times K1 - \frac{E1}{ROT \times K2} \qquad (5)$$

avec E1 = VALT + VD + R1 × IALT.

La résistance R1 dépend de la température θ des bobinages d'induit, suivant une relation du type :

$$R1 = Ro \times (1 + \alpha\theta) \qquad\qquad (6)$$

où θ désigne la température du bobinage induit ou, à défaut, la température au niveau du régulateur de tension batterie quand la température des bobinages ne peut être facilement mesurée ;
où Ro désigne la résistance de l'induit pour une température de 0°C ; et,
où α désigne un coefficient déterminé.

La variation de la chute de tension VD dans le pont redresseur est considérée comme négligeable en sorte que VD est considérée comme une constante (typiquement, VD est égale à environ 2 Volts). De même, la tension de sortie de l'alternateur VALT peut être considérée comme constante, du fait de la régulation (typiquement VALT est égale à environ 14,5 Volts). La relation (5) donne donc un réseau de caractéristiques du débit en fonction de la vitesse de rotation ROT, pour différentes valeurs du courant d'excitation Iex.

Ainsi qu'il est illustré à la figure 4, ce réseau de caractéristiques IALT = f(Iex) a l'allure des réseaux de caractéristiques relevées sur un alternateur réel.

Pour affiner la modélisation de l'alternateur, on peut choisir des constantes qui permettent de faire correspondre exactement la valeur de IALT calculée suivant le modèle proposé avec le débit d'un alternateur réel. On introduit à cet effet des valeurs additives C3, C4 et C5, qui interviennent comme suit :

$$IALT = (Iex + C3) \times K1 - \frac{E1}{(ROT + C4) \times K2} + C5 \qquad\qquad (7)$$

En résumé, la valeur de Iex est donnée suivant le modèle retenu par les trois relations (1), (6) et (7) données plus haut. La signification ou le rôle de chaque coefficient multiplicatif et de chaque valeur additive (qui est de préférence une constante) est la suivante :

- K1 est le rapport entre le courant de sortie IALT et le courant d'excitation Iexc de l'alternateur à vitesse de rotation élevée. Ce coefficient tient compte du rapport du nombre de spires entre inducteur et induit, et de la perte de flux entre le rotor et le stator ;
- K2 permet de contrôler la variation du courant de sortie IALT en fonction de la vitesse de rotation ROT, en dérivant vers la masse tout ou partie du courant (Iex + C3) × K1 ;
- C3 permet de prendre en compte l'effet de la rémanence du circuit magnétique sur l'excitation en décalant la valeur du courant d'excitation ;
- C4 permet de réaliser un décalage en abscisse sur la valeur de rotation ROT pour la caractéristique IALT = f(ROT) ; et,
- C5 permet de réaliser un décalage en ordonnée sur la valeur du débit IALT pour la caractéristique IALT = f(ROT).

Les constantes C3, C4 et C5 sont codées chacune sur 1 octet et agissent par addition. Elles sont donc aisées à mettre en oeuvre pour un microcontrôleur 8 bits.

Le coefficient K2 agit par multiplication. Sa valeur est peu précise et la multiplication peut généralement être réalisée facilement par de simples décalages de la valeur ROT + C4 . A cet effet, on choisit K2 égal à la puissance entière de 2 la plus proche de la valeur souhaitée. Au besoin, si une plus grande précision s'avère nécessaire, il est possible d'utiliser la fonction multiplication généralement câblée dans les microcontrôleurs 8 bits.

Le coefficient K1 agit aussi par multiplication. Par contre, il doit avoir une valeur précise et il peut être nécessaire d'utiliser la fonction multiplication généralement câblée dans les microcontrôleurs 8 bits.

Le choix de la valeur des coefficients multiplicatifs K1 et K2 et des constantes C3, C4 et C5 est guidé par la recherche de la corrélation entre le schéma équivalent de l'alternateur et un alternateur réel. Il s'agit de calculer ou d'ajuster les valeurs des constantes et des coefficients pour que la valeur IALT corresponde exactement au débit de l'alternateur réel. On peut procéder selon une méthode par approches successives.

Au début, on peut négliger les constantes C3, C4 et C5 (en sorte que C3=C4=C5=0), on peut négliger R1 (en sorte que E1 = VALT + VD), et on peut choisir K1 tel que K1 = IALT/Iex.

Les valeurs des constantes et les coefficients sont obtenues ensuite par approches successives, des points remarquables des courbes des caractéristiques IALT = f(ROT) permettant de les obtenir plus facilement par l'utilisation d'expressions simplifiées.

Par exemple, à vitesse de rotation élevée (de l'ordre de 20000 tr/min), l'inductance principale de l'induit a une valeur très importante et la résistance R2 équivalente ne dérive qu'un courant négligeable. Dans ce cas, la relation (7) s'écrit :

$$IALT = ((Iex + C3) \times K1) + C5 \qquad (8)$$

De plus, au point d'amorçage, on a IALT = 0. Dans ce cas, la relation (7) s'écrit :

$$((Iex + C3) \times K1) + C5 = \frac{E1}{(ROT + C4) \times K2} \qquad (9)$$

On notera que, pour une plus grande précisions, au moins certains des paramètres du modèle (coefficients multiplicatifs ou valeurs additives) peuvent être déterminés en dynamique, c'est-à-dire en faisant fonctionner l'alternateur. Par exemple, on peut faire fonctionner un alternateur de manière à ce qu'il débite un courant de valeur déterminée, et déterminer la valeur additive C4 à partir d'une mesure de la vitesse de rotation ROT correspondante. Cette opération peut faire partie des ajustements et réglages réalisés en fin de chaîne de montage.

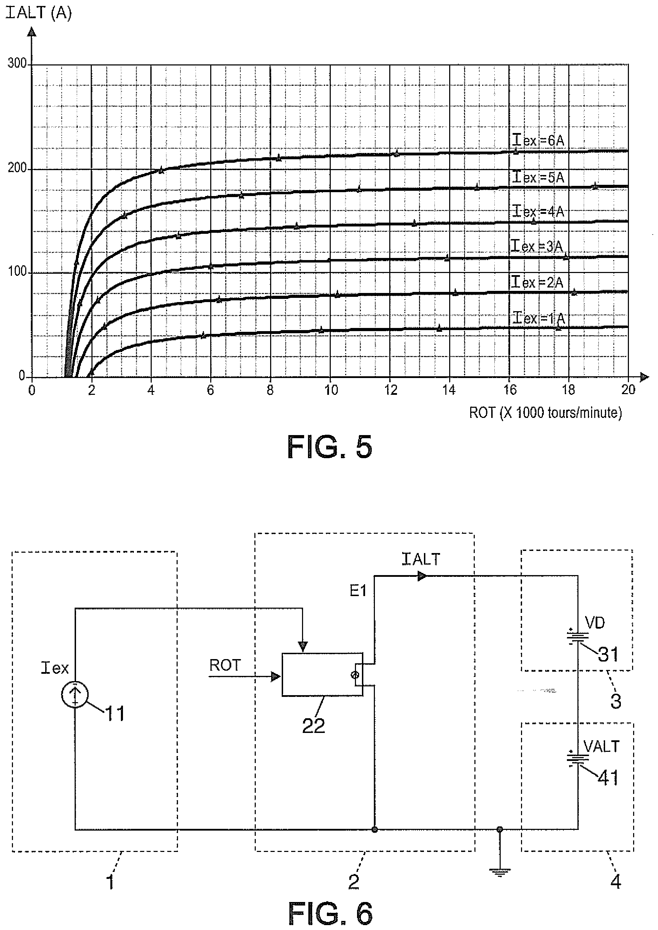

Le réseau de caractéristiques IALT = f(Iex) représenté à la figure 5 correspond au réseau de la figure 4 corrigé avec les constantes et les coefficients choisis pour correspondre exactement aux caractéristiques d'un alternateur réel (ici, un alternateur TG15 de VALEO).

Les valeurs retenues sont stockées en mémoire, une fois pour toutes. La mémoire peut être la ROM interne du microcontrôleur du régulateur.

Pour la programmation du microcontrôleur permettant de donner la valeur de IALT en fonctionnement, il est proposé deux solutions, qui vont maintenant être présentées.

Selon une première solution, on commence par calculer la résistance R1 de l'induit à l'aide de l'équation (6). La valeur de R1 intervient au second ordre sur le débit IALT de l'alternateur. D'autre part, la température des bobinages d'induit n'est pas accessible si on ne dispose pas d'un capteur de température au niveau de ces bobinages (environnement sévère). On peut alors se contenter d'utiliser la température $\theta$ au niveau du régulateur (environnement sévère, le régulateur étant disposé en général à l'arrière de la cage de l'alternateur).

On peut calculer R1 en utilisant directement l'équation (6), ou bien choisir une valeur de R1 en fonction de $\theta$ parmi quelques valeurs préprogrammées en mémoire ROM (dans ce cas on prévoit de préférence au moins quatre valeurs de R1, respectivement pour quatre plages de valeurs de $\theta$ distinctes).

Puis, on calcule IALT à l'aide des équations (1) et (7). Ces équations (1) et (7) contiennent chacune la valeur de IALT. En conséquence, le calcul de IALT doit se faire par approximations successives en commençant par exemple par IALT = 0 dans l'équation (1).

Selon une deuxième solution, il est proposé de ne pas faire intervenir directement la chute de tension R1×IALT dans la valeur de E1 (c'est-à-dire qu'on choisit R1 = 0).

En conséquence, la relation (1) devient :

$$E1 = VALT + VD \qquad (10)$$

et, l'équation (7) s'écrit :

$$IALT = (Iex + C3) \times K1 - \frac{(VALT + VD)}{(ROT + C4) \times K2} + C5 \qquad (11)$$

Avantageusement, il n'y a plus alors qu'une seule équation pour calculer la valeur de IALT, ce qui facilite le traitement par le microcontrôleur (il n'y a plus de calcul par approches successives). Par contre, l'influence de la température doit être prise en compte par les cinq constantes et coefficients.

Dans ce but, on définit de préférence au moins quatre jeux de constantes et de coefficients, chaque jeu étant lié à une plage de température déterminée du régulateur (ou mieux, de la température du bobinage de l'induit, si on peut la mesurer).

Par exemple, on peut choisir les quatre plages de température données dans le tableau 1 ci-dessous, correspondant à des seuils de 50°C et de 100°C.

Tableau 1

| Plages de températures |
|---|
| $\theta < 0°C$ |
| $0°C < \theta < 50°C$ |
| $50°C < \theta < 100°C$ |
| $100°C < \theta$ |

En conséquence, et pour cet exemple, les constantes et coefficients occupent une taille mémoire (en ROM) de 20 octets. Dans le tableau ainsi stocké en mémoire, on lit les deux coefficients multiplicatifs et les trois constantes additives correspondant à la plage de température dans laquelle se trouve le bobinage de l'induit (ou, à défaut, le régulateur de tension batterie) au moment du calcul de IALT.

La figure 6 donne le schéma équivalent de l'alternateur selon cette deuxième solution (suppression de la résistance R1).

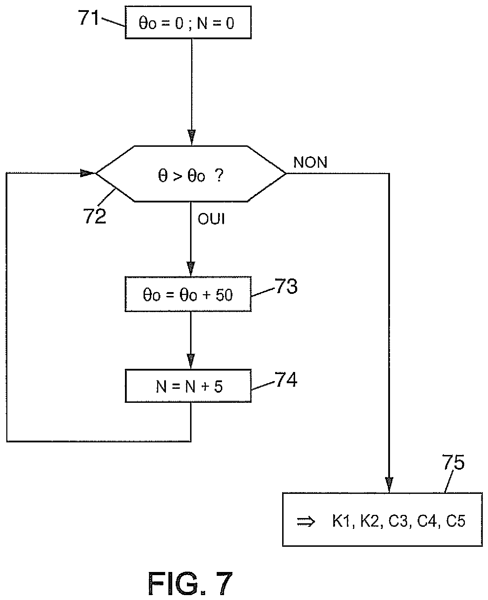

En référence à la figure 7, on va maintenant décrire un exemple d'algorithme de lecture des constantes et coefficients pour une température $\theta$ déterminée des bobinages d'induit ou du régulateur selon la deuxième solution. Cet exemple correspond au cas des quatre plages de valeurs de la température définies par la tableau 1 ci-dessus.

Dans une étape d'initialisation 71, on met à zéro une variable $\theta_0$ et une variable N.

Ensuite, dans une étape de test 72, on compare la valeur courante $\theta$ de la température à la variable $\theta_0$.

Si $\theta > \theta_0$ alors, dans une étape 73, on incrémente la variable $\theta_0$ de 50 unités, puis, dans une étape 74, on incrémente la variable N de 5 unités (en supposant qu'un jeu de constantes et de coefficients correspond à 5 mots mémoire à lire dans la mémoire ROM) et on retourne au test de l'étape 12.

Si au contraire $\theta < \theta_0$ alors, dans une étape 75, on lit les valeurs des coefficients K1 et K2, et les valeurs des constantes C3, C4 et C5 dans la mémoire ROM à l'adresse ADR+N, où ADR désigne l'adresse du premier paramètre (coefficient ou constante) du premier jeu, dans la mémoire ROM.

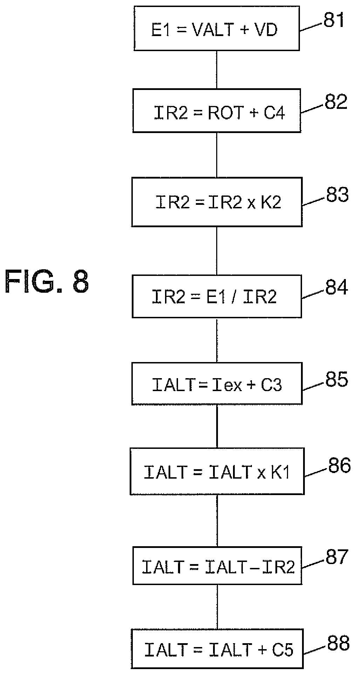

La figure 8 illustre un exemple d'algorithme de calcul du débit IALT de l'alternateur selon la deuxième solution, en utilisant les constantes et coefficients obtenus par exemple par l'algorithme de la figure 7.

Dans une première étape 81, on calcule la valeur de E1, en ajoutant les valeurs de VALT et de VD, suivant la relation (10). Les valeurs de VALT et de VD sont classiquement connues du microcontrôleur du régulateur. Dans une étape 82, on calcule ensuite une valeur intermédiaire notée IR2, qui correspond à la somme ROT + C4 de la valeur ROT de la vitesse de rotation (classiquement connue du microcontrôleur du régulateur) et de la constante C4 lue en mémoire. Puis, dans une étape 83, on multiplie la valeur IR2 par le coefficient K2 lu en mémoire. Enfin, dans une étape 84, on effectue la division de la valeur de E1 (calculée à l'étape 81) par la valeur IR2 (calculée à l'étape 83).

Ces étapes 81-84 permettent d'obtenir le second terme de l'équation (11) donnant le débit IALT de l'alternateur.

On notera que la division de l'étape 84 donnant le terme $\dfrac{E1}{(ROT + C4) \times K2}$ peut être difficile à réaliser en hardware dans les microcalculateurs de régulateurs, et c'est pourquoi elle peut être réalisée par programme.

Dans une étape 85, on ajoute la constante C3 lue en mémoire à la valeur du courant d'excitation Iex (qui peut être mesurée comme indiqué dans le document WO 02/071570 précité), pour obtenir une valeur intermédiaire du débit IALT de l'alternateur. Puis, dans une étape 86 on multiplie cette valeur intermédiaire de IALT par le coefficient K1 lu en mémoire.

Ces étapes 85-86 permettent d'obtenir le premier terme de l'équation (11) donnant le débit IALT de l'alternateur.

Dans une étape 87, on soustrait le second terme (obtenu à l'issue de l'étape 84) du premier terme (obtenu à l'issue de l'étape 86), afin d'obtenir une nouvelle valeur intermédiaire du débit IALT. On notera que, pour les faibles valeurs de la vitesse de rotation (inférieures à la vitesse d'amorçage), la valeur obtenue peut être négative. Dans ce cas, un test permet de transformer cette valeur négative en une valeur nulle.

Pour finir, dans une étape 88, on ajoute la constante C5 lue dans la mémoire ROM, à la valeur intermédiaire du débit IALT obtenue à l'étape 87, afin d'obtenir la valeur estimée IALT du courant débité par l'alternateur.

On notera que l'ordre des étapes 81-84, d'une part, et des étapes 85-86 d'autre part, peut être inversé. De même, l'étape 88 peut être effectuée avant l'étape 87. Dans ce cas, la constante C5 peut être ajoutée au second terme (obtenu à l'issue de l'étape 84) ou au premier terme (obtenu à l'issue de l'étape 86).

On notera également que l'expression mathématique de IALT donnée par l'équation (7) peut être formulée différemment, mais les différentes formes aboutissent à la même valeur de IALT en utilisant des coefficients et des constantes appropriés.

Par exemple, le coefficient K2 peut être remplacé par 1/K2. Dans ce cas, l'équation (7) devient :

$$IALT = (Iex + C3) \times K1 - \frac{E1 \times K2}{(ROT + C4)} + C5 \qquad (12)$$

Le coefficient K2 peut aussi être remplacé par K2/K1. Dans ce cas l'équation (7) devient :

$$IALT = (Iex + C3 - \frac{E1}{(ROT + C4) \times K2}) \times K1 + C5 \qquad (13)$$

Il y a des multiples combinaisons possibles. On choisira la forme la plus commode pour l'utilisation des coefficients et des constantes, c'est-à-dire celle qui facilite le plus les calculs réalisés par le microcontrôleur du régulateur de tension batterie.

Dans des modes de réalisation, l'unité de régulation d'un alternateur, i.e. le régulateur, comprend non seulement des moyens pour l'estimation du courant débité par l'alternateur tels que décrits ci-dessus, mais en outre des moyens de calcul du couple mécanique Ta appliqué sur l'arbre de l'alternateur, de la puissance utile Pu et/ou du rendement $\rho$ de l'alternateur :

En effet, le schéma équivalent simplifié permet de calculer le courant débité par l'alternateur, mais on peut en outre en déduire, par des calculs supplémentaires, d'autres caractéristiques de l'alternateur telles que le couple mécanique, la puissance et le rendement de l'alternateur. Les calculs du couple Ta et du rendement $\rho$ font intervenir le couple utile Tu, le couple Te lié aux pertes électriques et le couple Tm lié aux pertes mécaniques, qui peuvent être obtenus par des calculs supplémentaires à partir des informations disponibles au niveau du régulateur.

Ces calculs supplémentaires nécessitent une puissance de calcul plus importante que pour le calcul du courant débité IALT uniquement. En particulier, la multiplication et la division sont utilisées souvent, et sont avantageusement câblées dans le microprocesseur ou le microcontrôleur.

Le couple utile Tu dépend de la vitesse de rotation ROT et de la puissance utile Pu, qui est la puissance électrique disponible en sortie de l'alternateur et qui est donnée par la relation :

$$Pu = VALT \times IALT \qquad (14)$$

Partant de la valeur de la puissance utile Pu ainsi calculée, le couple utile Tu est obtenu par le calcul suivant:

$$Tu = \frac{Pu}{ROT} = \frac{VALT \times IALT}{ROT} \qquad (15)$$

Les pertes électriques dépendent principalement de la résistance R1 de l'induit. Par conséquent, la valeur du courant débité IALT qui est utilisée est de préférence obtenue à partir du schéma équivalent simplifié de la figure 1 car celui-ci fait intervenir cette résistance R1. Dans ce cas, le calcul du courant débité IALT est réalisé par approximations successives (par 4 itérations par exemple) comme cela a déjà été précisé. Le couple Te lié aux pertes électriques dépend de la puissance perdue en pertes électriques Pe et de la vitesse de rotation ROT. En première approximation, les pertes électriques Pe sont liées aux pertes Joule dans la résistance R1 et à la chute de tension dans le pont redresseur qui peut être estimée à 1,5 volt environ. Il s'ensuit que le couple Te peut être calculé suivant la formule:

$$Te = \frac{Pe}{ROT} = \frac{R1 \times IALT^2 + 1.5 \times IALT}{ROT} \qquad (16)$$

Si on désire plus de précision dans le calcul des pertes électriques, la valeur de la résistance R1 peut être corrigée en fonction du courant IALT débité par l'alternateur, pour tenir compte de l'échauffement du bobinage induit. On peut également tenir compte des pertes résistives dans l'inducteur et des pertes magnétiques, voire du courant d'excitation Iex prélevé par l'inducteur de l'alternateur.

Les pertes mécaniques se traduisent par un couple résistant Tm qui est variable en fonction de la vitesse de rotation ROT. En première approximation, ce couple Tm est une fonction du second degré de cette vitesse de rotation, à cause des pertes par ventilation. Dit autrement, on peut calculer le couple Tm par la formule suivante:

$$Tm = P1 \times (ROT)^2 + P1 \times (ROT) + P3 \qquad (17)$$

où P1, P2 et P3 sont des coefficients qui dépendent des caractéristiques de l'alternateur concerné (essentiellement les pertes par ventilation, les frottements internes étant négligeables), qui sont avantageusement connues du fabricant du régulateur.

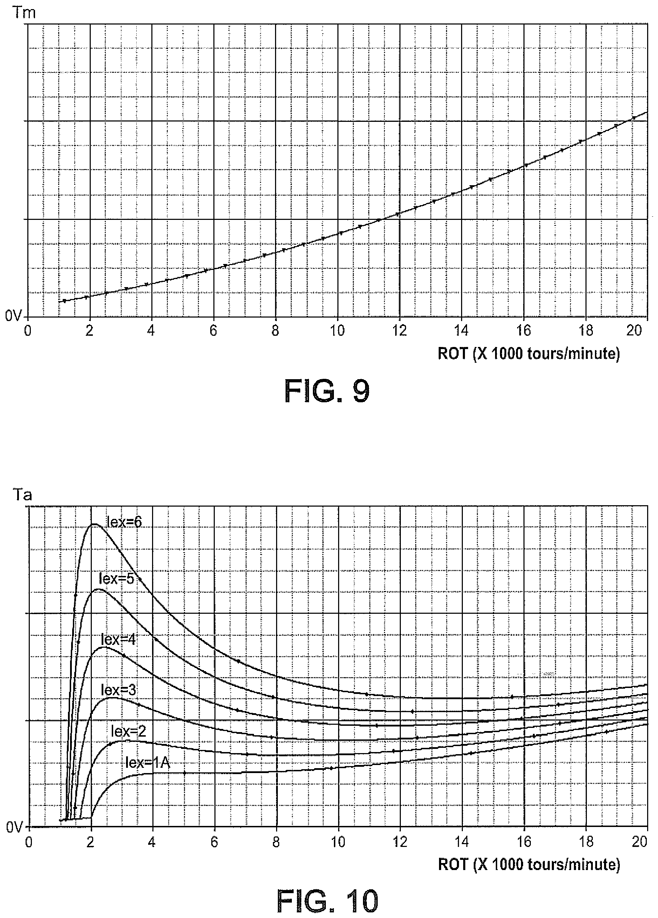

Le graphe de la figure 9 donne l'allure du couple Tm lié aux pertes mécaniques calculées selon la méthode ci-dessus.

En résumé, le calcul des couples Te et Tm liés aux pertes électriques et mécaniques, respectivement, nécessite la prise en compte des coefficients suivants:

- la résistance Rides bobinages du stator liée aux pertes électriques; et,
- des coefficients P1, P2 et P3 de la fonction du second degré, qui sont liés aux pertes mécaniques (essentiellement les pertes par ventilation) de l'alternateur.

Ayant calculé, les couples TU, Te et Tm comme précédemment indiqué, on peut ensuite calculer le couple résultant Ta appliqué à l'arbre de l'alternateur. C'est la somme du couple utile Tu, et des couples Te et Tm liés aux pertes électriques et mécaniques, respectivement:

$$Ta = Tu + Te + Tm \qquad (18)$$

Le graphe de la figure 10 donne l'allure du couple Ta ainsi calculé pour différentes valeurs du courant d'excitation.

Le rendement $\rho$ de l'alternateur est le rapport de la puissance utile Pu sur la puissance appliquée sur l'arbre (laquelle correspond au produit du couple correspondant Ta et de la vitesse de rotation ROT), ou bien le rapport du couple utile Tu sur le couple Ta appliqué à l'arbre. On calcule donc le rendement $\rho$ de l'alternateur par l'une des formules ci-dessous:

$$\rho = \frac{Pu}{Ta \times ROT} = \frac{Tu}{Ta} \qquad (19)$$

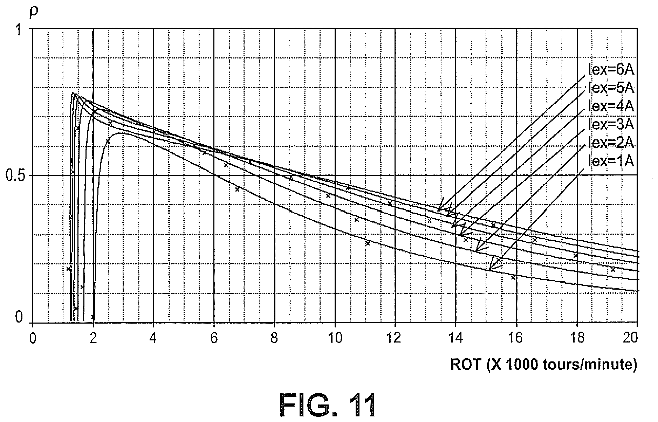

Le graphe de la figure 11 donne l'allure du rendement $\rho$ ainsi calculé pour différentes valeurs du courant d'excitation.

D'autres informations encore peuvent être calculées à partir de la valeur du courant IALT débité par l'alternateur, en fonction des besoins, les informations ci-dessus n'étant données qu'à titre d'exemple seulement.

Le régulateur de l'alternateur qui comprend les moyens de mise en oeuvre des modes de réalisations décrits ci-dessus peut être réalisé autour d'un microcontrôleur 8 bits à faible coût, tel qu'un microcontrôleur Motorola 6805 ™.

## Revendications

1. Procédé d'estimation du courant délivré par un alternateur pour véhicule automobile, comprenant le calcul d'une valeur de sortie (IALT) représentative du courant délivré par l'alternateur à partir d'une première valeur d'entrée (lex) représentative d'un courant d'excitation de l'alternateur d'une part, et d'une seconde valeur d'entrée (ROT) représentative de la vitesse de rotation de l'alternateur, d'autre part, dans lequel le calcul de la valeur de sortie comprend les étapes de :

   /a/ calcul (85,86) d'un premier terme sensiblement proportionnel à la première valeur d'entrée ;
   /b/ calcul (81-84) d'un second terme sensiblement inversement proportionnel à la seconde valeur d'entrée; et,
   /c/ soustraction (87) du second terme à partir du premier terme pour obtenir la valeur de sortie.

2. Procédé selon la revendication 1, dans lequel à l'étape /b/ la seconde valeur d'entrée est augmentée (82) d'une première valeur additive non nulle (C4) déterminée.

3.  Procédé selon la revendication 1 ou la revendication 2, dans lequel à l'étape /a/, la première valeur d'entrée est augmentée (85) d'une seconde valeur additive non nulle (C3).

4.  Procédé selon l'une quelconque des revendications 1 à 3, dans lequel le calcul de la valeur de sortie comprend en outre, après l'étape /c/, l'ajout (88) d'une troisième valeur additive non nulle (C5).

5.  Procédé selon l'une quelconque des revendications 1 à 4, dans lequel le second terme dépend d'un paramètre ($\theta$) représentatif de la température des bobinages d'induit de l'alternateur.

6.  Procédé selon l'une quelconque des revendications 1 à 4, dans lequel un jeu de paramètres comprenant un premier coefficient multiplicatif (K1) intervenant à l'étape /a/, un second coefficient multiplicatif (K2) intervenant à l'étape /b/, la première valeur additive (C4), la deuxième valeur additive (C3), et/ou la troisième valeur additive (C5), est sélectionné en fonction d'un paramètre ($\theta$) représentatif de la température des bobinages d'induit de l'alternateur.

7.  Procédé selon la revendication 5 ou la revendication 6, dans lequel le paramètre ($\theta$) représentatif de la température des bobinages d'induit de l'alternateur est mesuré au niveau d'une unité de régulation de la tension délivrée par l'alternateur.

8.  Procédé selon l'une quelconque des revendications 1 à 7, dans lequel la première valeur d'entrée est mesurée au niveau de l'unité de régulation de la tension délivrée par l'alternateur.

9.  Dispositif d'estimation du courant délivré par un alternateur pour véhicule automobile comprenant des moyens de calcul d'une valeur de sortie (IALT) représentative du courant délivré par l'alternateur qui sont configurés pour calculer ladite valeur de sortie à partir d'une première valeur d'entrée (Iex) représentative d'un courant d'excitation de l'alternateur d'une part, et d'une seconde valeur d'entrée (ROT) représentative de la vitesse de rotation de l'alternateur, d'autre part, dans lequel les moyens de calcul de la valeur de sortie comprennent:

    /a/ des premiers moyens de calcul configurés pour calculer (85,86) un premier terme sensiblement proportionnel à la première valeur d'entrée ;
    /b/ des deuxièmes moyens de calcul configurés pour calculer (81-84) un second terme sensiblement inversement proportionnel à la seconde valeur d'entrée; et,
    /c/ des troisièmes moyens de calcul configurés pour soustraire (87) le second terme du premier terme pour obtenir la valeur de sortie.

10. Dispositif selon la revendication 9, dans lequel les deuxièmes moyens de calcul sont configurés pour augmenter (82) la seconde valeur d'entrée d'une première valeur additive non nulle (C4) déterminée.

11. Dispositif selon la revendication 9 ou la revendication 10, dans lequel les premiers moyens de calcul sont configurés pour augmenter (85) la première valeur d'entrée d'une seconde valeur additive non nulle (C3).

12. Dispositif selon l'une quelconque des revendications 9 à 11, dans lequel les moyens de calcul de la valeur de sortie comprennent en outre, après les troisièmes moyens de calcul, des moyens pour ajouter (88) une troisième valeur additive non nulle (C5).

13. Dispositif selon l'une quelconque des revendications 9 à 12, dans lequel le second terme dépend d'un paramètre ($\theta$) représentatif de la température des bobinages d'induit de l'alternateur.

14. Dispositif selon l'une quelconque des revendications 9 à 12, comprenant en outre des moyens de sélection configurés pour sélectionner un jeu de paramètres comprenant un premier coefficient multiplicatif (K1) intervenant à l'étape /a/, un second coefficient multiplicatif (K2) intervenant à l'étape /b/, la première valeur additive (C4), la deuxième valeur additive (C3), et/ou la troisième valeur additive (C5), en fonction d'un paramètre ($\theta$) représentatif de la température des bobinages d'induit de l'alternateur.

15. Dispositif selon la revendication 13 ou la revendication 14, comprenant en outre des moyens de mesure pour mesurer le paramètre ($\theta$) représentatif de la température des bobinages d'induit de l'alternateur au niveau d'une unité de régulation de la tension délivrée par l'alternateur

16. Dispositif selon l'une quelconque des revendications 9 à 15, comprenant en outre des moyens pour mesurer la première valeur d'entrée au niveau de l'unité de régulation de la tension délivrée par l'alternateur.

17. Unité de régulation de la tension délivrée par un alternateur pour véhicule automobile, comprenant un dispositif selon l'une quelconque des revendications 9 à 16.

18. Unité de régulation selon la revendication 17, comprenant en outre des moyens de calcul du couple (Ta) appliqué à l'arbre de l'alternateur.

19. Unité de régulation selon la revendication 18, dans laquelle le couple appliqué à l'arbre de l'alternateur est calculé comme la somme du couple utile (Tu), du couple lié aux pertes électriques (Te), et du couple lié aux pertes mécaniques (Tm).

20. Unité de régulation selon la revendication 19, dans laquelle le couple utile (Tu) est calculé comme le rapport de la puissance utile (Pu) sur la vitesse de rotation (ROT) de l'alternateur, la puissance utile étant calculée comme le produit de la tension de sortie (VALT) de l'alternateur par la valeur estimée (IALT) du courant délivré par l'alternateur.

21. Unité de régulation selon la revendication 19 ou la revendication 20, dans laquelle le couple lié aux pertes électriques est calculé comme le rapport des pertes électriques (Pe) sur la vitesse de rotation (ROT) de l'alternateur, les pertes électriques étant calculées grâce à une fonction du second degré de la valeur estimée du courant (IALT) délivré par l'alternateur.

22. Unité de régulation selon l'une quelconque des revendications 19 à 21, dans laquelle le couple lié aux pertes mécaniques est calculé grâce à une fonction du second degré de la vitesse de rotation (ROT) de l'alternateur.

23. Unité de régulation selon l'une quelconque des revendications 17 à 22, comprenant en outre des moyens de calcul du rendement ($\rho$) de l'alternateur.

24. Unité de régulation selon la revendication 23, dans laquelle le rendement est calculé comme le rapport du couple utile (Tu) sur le couple (Ta) appliqué à l'arbre de l'alternateur.

25. Alternateur pour véhicule automobile, comprenant une unité de régulation de la tension délivrée par l'alternateur selon l'une quelconque des revendications 17 à 24.

**Patentansprüche**

1. Verfahren zur Schätzung des Stroms, der von einem Wechselstromgenerator für ein Kraftfahrzeug geliefert wird, welches die Berechnung eines Ausgangswertes (IALT), der für den von dem Wechselstromgenerator gelieferten Strom repräsentativ ist, aus einem ersten Eingangswert (Iex), der für einen Erregerstrom des Wechselstromgenerators repräsentativ ist, einerseits, und einem zweiten Eingangswert (ROT), der für die Drehzahl des Wechselstromgenerators repräsentativ ist, andererseits, umfasst, wobei die Berechnung des Ausgangswertes die Schritte umfasst:

/a/ Berechnung (85, 86) eines ersten Terms, der im Wesentlichen zu dem ersten Eingangswert proportional ist;
/b/ Berechnung (81-84) eines zweiten Terms, der im Wesentlichen zu dem zweiten Eingangswert umgekehrt proportional ist; und
/c/ Subtraktion (87) des zweiten Terms von dem ersten Term, um den Ausgangswert zu erhalten.

2. Verfahren nach Anspruch 1, wobei in Schritt /b/ der zweite Eingangswert um einen bestimmten ersten additiven, von null verschiedenen Wert (C4) erhöht wird (82).

3. Verfahren nach Anspruch 1 oder Anspruch 2, wobei in Schritt /a/ der erste Eingangswert um einen zweiten additiven, von null verschiedenen Wert (C3) erhöht wird (85).

4. Verfahren nach einem der Ansprüche 1 bis 3, wobei die Berechnung des Ausgangswertes außerdem, nach dem Schritt /c/, die Hinzufügung (88) eines dritten additiven, von null verschiedenen Wertes (C5) umfasst.

5. Verfahren nach einem der Ansprüche 1 bis 4, wobei der zweite Term von einem Parameter ($\theta$) abhängt, der für die Temperatur der Ankerwicklungen des Wechselstromgenerators repräsentativ ist.

**6.** Verfahren nach einem der Ansprüche 1 bis 4, wobei ein Satz von Parametern, der einen ersten Multiplikationsfaktor (K1), der in Schritt /a/ zur Anwendung kommt, einen zweiten Multiplikationsfaktor (K2), der in Schritt /b/ zur Anwendung kommt, den ersten additiven Wert (C4), den zweiten additiven Wert (C3) und/oder den dritten additiven Wert (C5) umfasst, in Abhängigkeit von einem Parameter ($\theta$) ausgewählt wird, der für die Temperatur der Ankerwicklungen des Wechselstromgenerators repräsentativ ist.

**7.** Verfahren nach Anspruch 5 oder Anspruch 6, wobei der Parameter ($\theta$), der für die Temperatur der Ankerwicklungen des Wechselstromgenerators repräsentativ ist, an einer Einheit zur Regelung der von dem Wechselstromgenerator gelieferten Spannung gemessen wird.

**8.** Verfahren nach einem der Ansprüche 1 bis 7, wobei der erste Eingangswert an der Einheit zur Regelung der von dem Wechselstromgenerator gelieferten Spannung gemessen wird.

**9.** Vorrichtung zur Schätzung des Stroms, der von einem Wechselstromgenerator für ein Kraftfahrzeug geliefert wird, welche Mittel zur Berechnung eines Ausgangswertes (IALT), der für den von dem Wechselstromgenerator gelieferten Strom repräsentativ ist, umfasst, welche dafür ausgelegt sind, den Ausgangswert aus einem ersten Eingangswert (Iex), der für einen Erregerstrom des Wechselstromgenerators repräsentativ ist, einerseits, und einem zweiten Eingangswert (ROT), der für die Drehzahl des Wechselstromgenerators repräsentativ ist, andererseits, zu berechnen, wobei die Mittel zur Berechnung des Ausgangswertes umfassen:

/a/ erste Berechnungsmittel, die dafür ausgelegt sind, einen ersten Term zu berechnen (85, 86), der im Wesentlichen zu dem ersten Eingangswert proportional ist;
/b/ zweite Berechnungsmittel, die dafür ausgelegt sind, einen zweiten Term zu berechnen (81-84), der im Wesentlichen zu dem zweiten Eingangswert umgekehrt proportional ist; und
/c/ dritte Berechnungsmittel, die dafür ausgelegt sind, den zweiten Term von dem ersten Term zu subtrahieren (87), um den Ausgangswert zu erhalten.

**10.** Vorrichtung nach Anspruch 9, wobei die zweiten Berechnungsmittel dafür ausgelegt sind, den zweiten Eingangswert um einen bestimmten ersten additiven, von null verschiedenen Wert (C4) zu erhöhen (82).

**11.** Vorrichtung nach Anspruch 9 oder Anspruch 10, wobei die ersten Berechnungsmittel dafür ausgelegt sind, den ersten Eingangswert um einen zweiten additiven, von null verschiedenen Wert (C3) zu erhöhen (85).

**12.** Vorrichtung nach einem der Ansprüche 9 bis 11, wobei die Mittel zur Berechnung eines Ausgangswertes außerdem, nach den dritten Berechnungsmitteln, Mittel zum Hinzufügen (88) eines dritten additiven, von null verschiedenen Wertes (C5) umfassen.

**13.** Vorrichtung nach einem der Ansprüche 9 bis 12, wobei der zweite Term von einem Parameter ($\theta$) abhängt, der für die Temperatur der Ankerwicklungen des Wechselstromgenerators repräsentativ ist.

**14.** Vorrichtung nach einem der Ansprüche 9 bis 12, welche außerdem Auswahlmittel umfasst, die dafür ausgelegt sind, einen Satz von Parametern, der einen ersten Multiplikationsfaktor (K1), der in Schritt /a/ zur Anwendung kommt, einen zweiten Multiplikationsfaktor (K2), der in Schritt /b/ zur Anwendung kommt, den ersten additiven Wert (C4), den zweiten additiven Wert (C3) und/oder den dritten additiven Wert (C5) umfasst, in Abhängigkeit von einem Parameter ($\theta$) auszuwählen, der für die Temperatur der Ankerwicklungen des Wechselstromgenerators repräsentativ ist.

**15.** Vorrichtung nach Anspruch 13 oder Anspruch 14, welche außerdem Messmittel zum Messen des Parameters ($\theta$), der für die Temperatur der Ankerwicklungen des Wechselstromgenerators repräsentativ ist, an einer Einheit zur Regelung der von dem Wechselstromgenerator gelieferten Spannung umfasst.

**16.** Vorrichtung nach einem der Ansprüche 9 bis 15, welche außerdem Mittel zum Messen des ersten Eingangswertes an der Einheit zur Regelung der von dem Wechselstromgenerator gelieferten Spannung umfasst.

**17.** Einheit zur Regelung der von einem Wechselstromgenerator für ein Kraftfahrzeug gelieferten Spannung, welche eine Vorrichtung nach einem der Ansprüche 9 bis 16 umfasst.

**18.** Einheit zur Regelung nach Anspruch 17, welche außerdem Mittel zur Berechnung des Drehmoments (Ta) umfasst, das auf die Welle des Wechselstromgenerators ausgeübt wird.

**19.** Einheit zur Regelung nach Anspruch 18, wobei das Drehmoment, das auf die Welle des Wechselstromgenerators ausgeübt wird, als die Summe des Nutzdrehmoments (Tu), des mit den elektrischen Verlusten verbundenen Drehmoments (Te) und des mit den mechanischen Verlusten verbundenen Drehmoments (Tm) berechnet wird.

**20.** Einheit zur Regelung nach Anspruch 19, wobei das Nutzdrehmoment (Tu) als das Verhältnis der Nutzleistung (Pu) zur Drehzahl (ROT) des Wechselstromgenerators berechnet wird, wobei die Nutzleistung als das Produkt der Ausgangsspannung (VALT) des Wechselstromgenerators und des geschätzten Wertes (IALT) des von dem Wechselstromgenerator gelieferten Stroms berechnet wird.

**21.** Einheit zur Regelung nach Anspruch 19 oder Anspruch 20, wobei das mit den elektrischen Verlusten verbundene Drehmoment als das Verhältnis der elektrischen Verluste (Pe) zur Drehzahl (ROT) des Wechselstromgenerators berechnet wird, wobei die elektrischen Verluste mithilfe einer quadratischen Funktion des geschätzten Wertes des von dem Wechselstromgenerator gelieferten Stroms (IALT) berechnet werden.

**22.** Einheit zur Regelung nach einem der Ansprüche 19 bis 21, wobei das mit den mechanischen Verlusten verbundene Drehmoment mithilfe einer quadratischen Funktion der Drehzahl (ROT) des Wechselstromgenerators berechnet wird.

**23.** Einheit zur Regelung nach einem der Ansprüche 17 bis 22, welche außerdem Mittel zur Berechnung des Wirkungsgrades ($\rho$) des Wechselstromgenerators umfasst.

**24.** Einheit zur Regelung nach Anspruch 23, wobei der Wirkungsgrad als das Verhältnis des Nutzdrehmoments (Tu) zum auf die Welle des Wechselstromgenerators ausgeübten Drehmoment (Ta) berechnet wird.

**25.** Wechselstromgenerator für ein Kraftfahrzeug, welcher eine Einheit zur Regelung der von dem Wechselstromgenerator gelieferten Spannung nach einem der Ansprüche 17 bis 24 umfasst.

**Claims**

**1.** Method for estimating the current delivered by an alternator for a motor vehicle, comprising the calculation of an output value (IALT) representative of the current delivered by the alternator from a first input value (Iex) representative of an excitation current of the alternator on the one hand, and of a second input value (ROT) representative of the speed of rotation of the alternator on the other hand, in which the calculation of the output value comprises the steps of:

/a/ calculation (85, 86) of a first term substantially proportional to the first input value;
/b/ calculation (81-84) of a second term substantially inversely proportional to the second input value; and,
/c/ subtraction (87) of the second term from the first term to obtain the output value.

**2.** Method according to Claim 1, in which, in the step /b/, the second input value is increased (82) by a first determined non-zero additive value (C4).

**3.** Method according to Claim 1 or Claim 2, in which, in the step /a/, the first input value is increased (85) by a second non-zero additive value (C3) .

**4.** Method according to any one of Claims 1 to 3, in which the calculation of the output value further comprises, after the step /c/, the addition (88) of a third non-zero additive value (C5).

**5.** Method according to any one of Claims 1 to 4, in which the second term depends on a parameter ($\theta$) representative of the temperature of the armature windings of the alternator.

**6.** Method according to any one of Claims 1 to 4, in which a set of parameters comprising a first multiplying coefficient (K1) involved in the step /a/, a second multiplying coefficient (K2) involved in the step /b/, the first additive value (C4), the second additive value (C3), and/or the third additive value (C5), is selected as a function of a parameter ($\theta$) representative of the temperature of the armature windings of the alternator.

7. Method according to Claim 5 or Claim 6, in which the parameter ($\theta$) representative of the temperature of the armature windings of the alternator is measured on a regulation unit regulating the voltage delivered by the alternator.

8. Method according to any one of Claims 1 to 7, in which the first input value is measured on the regulation unit regulating the voltage delivered by the alternator.

9. Device for estimating the current delivered by an alternator for a motor vehicle comprising means for calculating an output value (IALT) representative of the current delivered by the alternator which are configured to calculate said output value from a first input value (Iex) representative of an excitation current of the alternator on the one hand, and of a second input value (ROT) representative of the speed of rotation of the alternator on the other hand, in which the output value calculation means comprise:

   /a/ first calculation means configured to calculate (85, 86) a first term substantially proportional to the first input value;
   /b/ second calculation means configured to calculate (81-84) a second term substantially inversely proportional to the second input value; and,
   /c/ third calculation means configured to subtract (87) the second term from the first term to obtain the output value.

10. Device according to Claim 9, in which the second calculation means are configured to increase (82) the second input value by a first determined non-zero additive value (C4).

11. Device according to Claim 9 or Claim 10, in which the first calculation means are configured to increase (85) the first input value by a second non-zero additive value (C3).

12. Device according to any one of Claims 9 to 11, in which the output value calculation means further comprise, after the third calculation means, means for adding (88) a third non-zero additive value (C5) .

13. Device according to any one of Claims 9 to 12, in which the second term depends on a parameter ($\theta$) representative of the temperature of the armature windings of the alternator.

14. Device according to any one of Claims 9 to 12, further comprising selection means configured to select a set of parameters comprising a first multiplying coefficient (K1) involved in the step /a/, a second multiplying coefficient (K2) involved in the step /b/, the first additive value (C4), the second additive value (C3), and/or the third additive value (C5), as a function of a parameter ($\theta$) representative of the temperature of the armature windings of the alternator.

15. Device according to Claim 13 or Claim 14, further comprising measurement means for measuring the parameter ($\theta$) representative of the temperature of the armature windings of the alternator on a regulation unit regulating the voltage delivered by the alternator.

16. Device according to any one of Claims 9 to 15, further comprising means for measuring the first input value on the regulation unit regulating the voltage delivered by the alternator.

17. Regulation unit regulating the voltage delivered by an alternator for a motor vehicle, comprising a device according to any one of Claims 9 to 16.

18. Regulation unit according to Claim 17, further comprising means for calculating the torque (Ta) applied to the shaft of the alternator.

19. Regulation unit according to Claim 18, in which the torque applied to the shaft of the alternator is calculated as the sum of the useful torque (Tu), of the torque linked to the electrical losses (Te), and of the torque linked to the mechanical losses (Tm).

20. Regulation unit according to Claim 19, in which the useful torque (Tu) is calculated as the ratio of the useful power (Pu) to the speed of rotation (ROT) of the alternator, the useful power being calculated as the product of the output voltage (VALT) of the alternator by the estimated value (IALT) of the current delivered by the alternator.

21. Regulation unit according to Claim 19 or Claim 20, in which the torque linked to the electrical losses is calculated as the ratio of the electrical losses (Pe) to the speed of rotation (ROT) of the alternator, the electrical losses being calculated using a function of the second degree of the estimated value of the current (IALT) delivered by the alternator.

22. Regulation unit according to any one of Claims 19 to 21, in which the torque linked to the mechanical losses is calculated using a function of the second degree of the speed of rotation (ROT) of the alternator.

23. Regulation unit according to any one of Claims 17 to 22, further comprising means for calculating the efficiency ($\rho$) of the alternator.

24. Regulation unit according to Claim 23, in which the efficiency is calculated as the ratio of the useful torque (Tu) to the torque (Ta) applied to the shaft of the alternator.

25. Alternator for a motor vehicle, comprising a regulation unit regulating the voltage delivered by the alternator according to any one of Claims 17 to 24.

FIG. 1

FIG. 2

**FIG. 3**

**FIG. 4**

FIG. 5

FIG. 6

71 — $\theta_o = 0 \; ; N = 0$

$\theta > \theta_o \; ?$ — NON

72

OUI

$\theta_o = \theta_o + 50$ — 73

$N = N + 5$ — 74

75

$\Rightarrow$ K1, K2, C3, C4, C5

FIG. 7

FIG. 8

E1 = VALT + VD — 81

IR2 = ROT + C4 — 82

IR2 = IR2 x K2 — 83

IR2 = E1 / IR2 — 84

IALT = Iex + C3 — 85

IALT = IALT x K1 — 86

IALT = IALT − IR2 — 87

IALT = IALT + C5 — 88

Tm

ROT (X 1000 tours/minute)

# FIG. 9

Ta

Iex=6

Iex=5

Iex=4

Iex=3

Iex=2

Iex=1A

ROT (X 1000 tours/minute)

# FIG. 10

FIG. 11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 02071570 A
- DE 19941004 A1
- WO 03058793 A
- EP 1063764 A